# EUROPÄISCHE PATENTSCHRIFT

(11) **EP 0 891 602 B1**
(45) Veröffentlichungstag und Bekanntmachung des Hinweises auf die Patenterteilung: **26.09.2001**
(21) Anmeldenummer: 97916427.4
(22) Anmeldetag: 02.04.1997
(51) Int. Cl.: G06K 19/077

(54) **ELEKTRONISCHE KARTE MIT EINER GEHÄUSEEINRICHTUNG FÜR EINE DARIN IMPLEMENTIERTE ELEKTRONISCHE SCHALTUNG SOWIE EIN VERFAHREN ZUR HERSTELLUNG EINER DERARTIGEN KARTE**
ELECTRONIC CARD WITH A HOUSING FOR AN ELECTRONIC CIRCUIT IMPLEMENTABLE THEREIN, AND A METHOD OF MANUFACTURING SUCH A CARD
CARTE ELECTRONIQUE AVEC UN BOITIER POUR UN CIRCUIT ELECTRONIQUE IMPLANTABLE DANS LEQUELLE BOITIER , ET PROCEDE DE FABRICATION D'UNE TELLE CARTE

(30) Priorität: 03.04.1996 DE 29605937 U; 03.04.1996 DE 19613543
(43) Veröffentlichungstag der Anmeldung: 20.01.1999
(73) Patentinhaber: Bunert, Peter, 75245 Neulingen (DE)
(72) Erfinder: Bunert, Peter, 75245 Neulingen (DE)
(74) Vertreter: Leitner, Waldemar, Dr. techn.
(86) Internationale Anmeldenummer: EP9701658
(87) Internationale Veröffentlichungsnummer: WO9738396

(56) Entgegenhaltungen:
- DE-A- 3 707 252
- DE-U- 9 420 774
- FR-A- 2 673 065

## Beschreibung

Die Erfindung betrifft eine elektronische Karte für elektromagnetisch bewirkten Datenaustausch, die eine elektronische Schaltung aufweist, die in einer Gehäuseeinrichtung aufgenommen ist.

Elektronische Karten mit einer implementierbaren elektronischen Schaltung sind bekannt und werden z. B. als Telephonkarte, als Kreditkarte mit integrierter Telephonkartenfunktion, etc. verwendet. Hierbei wird die elektronische Schaltung in Form eines hermetisch gekapselten Gehäuses auf das Trägerelement der elektronischen Karte aufgesetzt. Eine derartige Vorgangsweise besitzt den Nachteil, daß sie nur kostenaufwendig durchführbar ist, da die Kapselung des Mikrochips aufgrund der Temperaturanfälligkeit der elektronischen Bauteile nur schwierig durchzuführen ist.

Seit kurzem werden derartige elektronische Karten nicht nur für die o.g. Funktionen eingesetzt. Vielmehr werden sie auch in sogenannten Transponder-Karten, wie z.B. in elektronischen Karten für ein Radiofrequenz-Identifikations-System zum Wiederauffinden von Gepäckstücken, eingesetzt. Hierbei besteht die elektronische Schaltung aus einem Antennenelement und einer mit diesem Antennenelement über dünne Drähte verbundenen Auswertungseinheit. Eine derartige, elektronische Schaltung ist aufgrund ihrer räumlichen Ausdehnung nicht mehr-wie z.B. ein Mikrochip - einfach durch ein Kunststoffspritzgußverfahren kapselbar, da durch den Spritzdruck die das Antennenelement und die Auswertungseinheit der elektronischen Schaltung verbindenden Drähte beschädigt würden. Man ist daher zur Zeit gezwungen, diese elektronische Schaltung durch Einlamenieren zu verschließen, was bei einer Temperatur von 130° für 20 bis 30 Minuten geschieht. Eine derartige Vorgangsweise besitzt den Nachteil, daß die hierzu erforderliche Arbeitstemperatur für die elektronische Schaltung in der Regel an der Grenze des technisch Möglichen liegt, so daß bei der jetzigen Produktion derartiger elektronischer Karten mit einer hohen Ausfallrate gerechnet wird.

Klarstellend zu den oben genannten Karten soll noch aufgeführt werden, daß es sich bei den gattungsgemäßen Karten nicht um elektronische Karten, wie sie zum Beispiel in PC's als Steckkarten eingesetzt werden, und um Karten, deren Gehäuseeinrichtung bereits das endgültige Gehäuse für die elektronische Karte bilden, handelt.

Es ist daher Aufgabe der Erfindung, eine elektronische Karte der eingangs genannten Art derart weiterzuentwickeln, daß sie bei einer einfachen Herstellung einen guten Schutz für die in ihr aufgenommene elektronische Schaltung bietet.

Diese Aufgabe wird erfindungsgemäß dadurch gelöst, daß die Gehäuseeinrichtung mindestens ein Bodenelement und mindestens ein Deckelelement aufweist, daß die elektronische Schaltung zwischen den Innenflächen dieser beiden Elemente aufgenommen ist, daß im Bodenelement und/oder im Deckelelement zumindest eine Vertiefung ausgebildet ist, in der die elektronische Schaltung eingesetzt ist, daß die Kontur der Vertiefung auf die Außenkontur der elektronischen Schaltung abgestimmt ist, daß das Deckelelement die elektronische Schaltung zumindest teilweise überdeckt, und daß die Gehäuseeinrichtung durch eine Ummantelung aus Kunststoff umgeben ist.

Durch die erfindungsgemäßen Maßnahmen wird in vorteilhafter Art und Weise eine Gehäuseeinrichtung für eine elektronische Schaltung einer elektronischen Karte geschaffen, die in vorteilhafter Art und Weise durch ein einfaches Kunststoffspritzgußverfahren herstellbar ist. Die erfindungsgemäßen, zumindest im Bodenelement der Gehäuseeinrichtung vorgesehenen Vertiefungen erlauben in vorteilhafter Art und Weise auch die Aufnahme von räumlich ausgedehnteren elektronischen Schaltungen, welche nach dem Aufeinanderlegen von Bodenelement und Deckelelement und ggfs. einem Verbinden dieser beiden Elemente sicher und temperaturgeschützt im Inneren der Gehäuseeinrichtung aufgenommen sind. Die erfindungsgemäße Gehäuseeinrichtung kann dann zusammen mit der gegen mechanische und/oder thermische Einflüße geschützten elektronischen Schaltung in ein Kunststoff-Spritzgußwerkzeug eingelegt und umspritzt werden, um die endgültige elektronische Karte herzustellen.

Eine vorteilhafte Weiterbildung der Erfindung sieht vor, daß das Bodenelement und/oder das Deckelelement der erfindungsgemäßen Gehäuseeinrichtung zumindest zwei räumlich voneinander separierte Vertiefungen zur Aufnahme zweier separater Bauteile der elektronischen Schaltung aufweist, wobei diese beide Vertiefungen durch zumindest eine Aussparung zur Aufnahme der die beiden vorgenannten Teile verbindenden Leitungen verbunden sind. Eine derartige Ausgestaltung besitzt den Vorteil, daß hierdurch in vorteilhafter Art und Weise auch aus mehreren räumlich getrennten Bauteilen bestehende elektronische Schaltungen mechanisch und/oder thermisch geschützt in der erfindungsgemäßen Gehäuseeinrichtung aufgenommen werden können.

Eine weitere vorteilhafte Weiterbildung der Erfindung sieht vor, daß eine der beiden Vertiefungen als Aufnahme für ein Antennenelement und die andere der beiden Vertiefungen als Aufnahme für eine Auswertungseinheit der elektronischen Schaltung ausgebildet ist. Ein derartiger Aufbau eignet sich besonders für eine als Radiofrequenz-ldentifikations-System einsetzbare elektronische Karte.

Eine weitere vorteilhafte Weiterbildung der Erfindung sieht vor, daß die jeweilige Gehäuseeinrichtung aus elastischem Material ausgebildet ist. Hierdurch wird in vorteilhafter Art und Weise ein flexibler Aufbau der elektronischen Karte erreicht.

Weitere vorteilhafte Weiterbildungen der Erfindung sind Gegenstand der Unteransprüche.

Weitere Einzelheiten und Vorteile der Erfindung sind dem Ausführungsbeispiel zu entnehmen, daß im folgenden anhand der Figuren beschrieben wird. Es zeigen:
- Figur 1: ein erstes Ausführungsbeispiel einer Gehäuseeinrichtung für eine elektronische Schaltung einer elektronischen Karte,
- Figur 2: ein zweites Ausführungsbeispiel einer Gehäuseeinrichtung für eine elektronische Schaltung einer elektronischen Karte, und
- Figur 3: eine aus der Gehäuseeinrichtung der Figur 2 aufgebaute elektronische Karte.

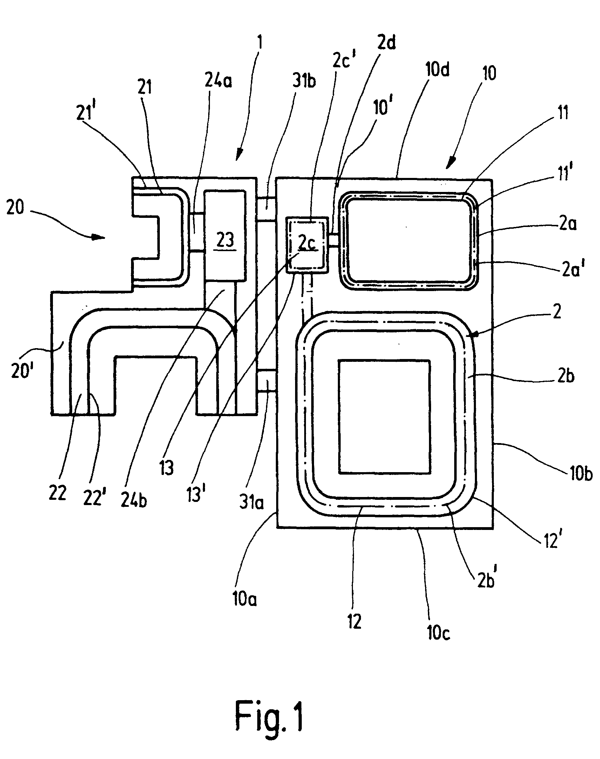

Das in Figur 1 dargestellte Ausführungsbeispiel einer Gehäuseeinrichtung 1 zur Aufnahme einer nur schematisch und strichpunktiert dargestellten elektronischen Schaltung 2 gliedert sich im wesentlichen in ein Bodenelement 10 und ein Deckelelement 20, welche durch Verbindungselemente 31a, 31b derart miteinander verbunden sind, daß das Deckelelement 20 auf das Bodenelement 10 verschwenkt werden kann, so daß eine Innenfläche 10' des Bodenelements 10 mit einer Innenfläche 20' des Deckelelements 20 in Anlage kommt. Es war an dieser Stelle festzuhalten, daß es zwar vorteilhaft ist, das Bodenelement 10 und das Deckelelement 20 über die Verbindungselemente 31a, 31b miteinander zu verbinden, daß es aber auch durchaus möglich ist, diese Verbindungselemente 31a, 31 b entfallen zu lassen, so daß dann die Gehäuseeinrichtung 1 aus zwei separaten Teilen 10, 20 besteht.

Das Bodenelement 10 der Gehäuseeinrichtung 1 besitzt eine im wesentlichen rechteckige Form, die durch Längsränder 10a und 10b und Querränder 10c und 10d begrenzt wird. Die Größe des Bodenelements 10 ist dabei etwas kleiner als die Grundfläche einer die beschriebene Gehäuseeinrichtung 1 verwendenden elektronischen Karte. Das Bodenelement 10 weist zwei Vertiefungen 11 und 12 auf, welche zur Aufnahme eines ersten Antennenelements 2a bzw. zur Aufnahme eines zweiten Antennenelements 2b der elektronischen Schaltung 2 dienen. Desweiteren weist das Bodenelement 10 eine Öffnung 13 für einen Mikrochip 2c auf, welcher von der Oberfläche der elektronischen Karte her zugänglich sein soll. Wie aus Figur 1 leicht ersichtlich ist, ist die Randkontur 11', 12' der Vertiefungen 11, 12 und diejenige (13') der Öffnung 13 auf die Außenkontur 2a', 2b', 2c' der jeweiligen Bauteile 2a, 2b, 2c der elektronischen Schaltung 2 abgestimmt, so daß diese Bauteile 2a-2c der elektronischen Schaltung 2 im wesentlich lagerfixiert im Bodenelement 10 der Gehäuseeinrichtung 1 aufgenommen sind.

Das Deckelelement 20 der Gehäuseeinrichtung 1 ist derart ausgebildet, daß nach einem Umklappen des Deckelelements 20 um die Verbindungselemente 31a, 31b auf das Bodenelement 10 diejenigen Bereiche der elektronischen Schaltung 2 vom Deckelelement 20 überdeckt werden, welche gegen mechanische und/oder thermische Einflüße geschützt werden sollen: Das Deckelelement 20 weist daher eine mit der Vertiefung 11 des Bodenelements 10 zusammenwirkende weitere Vertiefung 21 sowie eine mit der Vertiefung 12 des Bodenelements 10 zusammenwirkende weitere Vertiefung 22 auf, welche im montierten Zustand der Gehäuseeinrichtung 1 zumindest teilweise über den Vertiefungen 11 bzw. 12 liegen: Zu Illustrationszwecken wird angenommen, daß die elektronische Schaltung 2 nicht erfordert, daß der in Figur 1 rechte Teil des in der Vertiefung 11 aufgenommenen, ersten Antennenelements 2a vom Deckelelement 20 gegen thermische und/oder mechanische Einflüße abgeschirmt wird. Demzufolge erstreckt sich der obere Bereich des Deckelelements 20 nicht über dessen volle Breite b, sondern ist in diesen Richtung verkürzt ausgebildet. In entsprechender Art und Weise ist unter der Annahme, daß der untere Teil des zweiten Antennenelements 2b, wenn es in der Vertiefung 12 aufgenommen ist, nicht gegen die vorstehend genannten Einflüße geschutzt werden muß, vorgesehen, daß das Deckelelement 20, derart ausgebildet ist, das es nicht den unteren Bereich des zweiten Antennenelements 2b der elektronischen Schaltung 2 überdeckt.

In entsprechender Art und Weise weist das Deckelelement 20 der Gehäuseeinrichtung 1 eine Öffnung 23 für den Mikrochip 2c der elektronischen Schaltung auf. Um nun die elektronischen Bauteile 2a-2c der elektronischen Schaltung 2 verbindende Verbindungsdrähte 2d, welche typischerweise einen Durchmesser von 6/100 mm aufweisen, gegen Wärme und Zerreißen geschützt in der Gehäuseeinrichtung 1 aufnehmen zu können, weist - wie in Figur 1 dargestellt - das Deckelelement 20 Aussparungen 24a, 24b für die Verbindungsdrähte 2d auf, welche die Öffnung 23 mit den weiteren Vertiefungen 21, 22 verbinden. An diese Stelle soll angemerkt werden, daß es durchaus auch möglich ist, daß dieses Aussparungen 24a, 24b auch im Bodenelement 10 der Gehäuseeinrichtung 1 angeordnet sein können, und daß evtl. dann die Aussparungen 24a, 24b im Deckelelement 20 der Gehäuseeinrichtung 1 entfallen. Es ist desweiteren auch möglich, anstatt der Verbindungsdrähte 2d Folien zu verwenden.

Dem Fachmann ist aus obiger Beschreibung ersichtlich, daß auch im Deckelelement die Ausbildung und Andordnung der Vertiefungen 21,22 und der Öffnung 23 auf die Außenkonturen 2a', 2b', 2c' der elektronischen Bestandteile 2a-2c der elektronischen Schaltung 2, welche in dem durch die Innenflächen 10' und 20' der Elemente 10, 20 begrenzten Innenraum der Gehäuseeinrichtung 1 aufzunehmen ist, abgestimmt sind. Wichtig hierbei ist nur, daß diese Vertiefungen 11, 12 bzw. 21, 22 bzw. Öffnungen 13, 23 derart ausgebildet sind, daß in ihnen die elektronischen Bauteile 2a-2c der elektronischen Schaltung 2 gegen eine mechanische und/oder thermische Beschädigung hinreichend geschützt aufnehmbar sind.

Bei der beschriebenen Konstruktion ist außerdem von Vorteil, daß die Gehäuseeinrichtung 1 in einem einfach durchzuführenden Arbeitsgang durch ein Kunststoff-Spritzgußverfahren herstellbar ist, wobei in vorteilhafter Art und Weise auch als Material, das die Gehäuseeinrichtung 1 ausbildet, ein elastischer Kunststoff eingesetzt werden kann. Es ist aber auch möglich, zur Ausbildung der Gehäuseeinrichtung 1 ein starres Kunststoffmaterial zu verwenden.

Nachdem nun die Gehäuseeinrichtung 1 wie vorstehend beschrieben ausgebildet wurde, werden die Bestandteile 2a-2d der elektronischen Schaltung 2 in die Vertiefungen 11, 12 des Bodenelements 10 eingelegt. Danach wird das Deckelelement 20 um die Verbindungselemente 31a, 31b auf das Bodenelement 10 geschwenkt, wobei die Verbindungsdrähte 2d in den Aussparungen 24a, 24b des Deckelelements 20 aufgenommen werden. Danach wird das Bodenelement 10 mit dem Deckelelement 20 zumindest punktuell - vorzugsweise durch Verkleben oder Verrasten oder Verklemmen oder Verschweißen - verbunden, so daß das Deckelelement 20 auf dem Bodenelement 10 fixiert wird. Hierdurch wird auch eine Transportsicherung für die elektronische Schaltung 2 ausgebildet, die verhindert, daß bei einer Handhabung oder einem Transport die elektronische Schaltung 2 aus der Gehäuseeinrichtung 1 herausfallen kann.

Die derart gebildete Einheit wird dann in ein Kunststoff-Spritzgußwerkzeug eingelegt und durch ein Kunststoff-Spritzgußverfahren zur Ausbildung der fertigen elektronischen Karte umspritzt, wobei die nicht vom Deckelelement 20 abgedeckten, unempfindlichen Bereich der elektronischen Bauteile 2a-2d ummantelt werden.

Die beschriebene Gehäuseeinrichtung 1 zur Aufnahme der elektronischen Schaltung 2 der elektronischen Karte zeichnet sich dadurch aus, daß die die elektronische Schaltung 2 schützend aufnehmende Gehäuseeinrichtung 1 besonders einfach und daher kostengünstig durch ein Kunststoff-Spritzgußverfahren hergestellt werden kann. Außerdem ist auf diese Art und Weise möglich, flexible elektronische Karten zu fertigen.

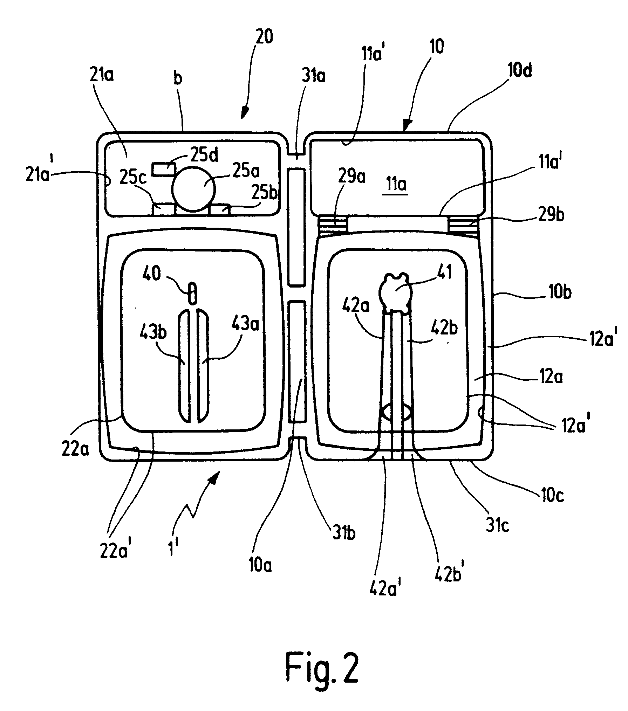

In Figur 2 ist nur ein zweites Ausführungsbeispiel einer Gehäuseeinrichtung 1' dargestellt, welches seinem Grundaufbau nach der Gehäuseeinrichtung 1 des in Figur 1 dargestellten ersten Ausführungsbeispiels entspricht, so daß gleiche und einander entsprechende Teile mit den gleichen Bezugszeichen versehen und nicht mehr näher beschrieben werden müssen.

Einer der Unterschiede zwischen der Gehäuseeinrichtung 1 und der Gehäuseeinrichtung 1' besteht darin, daß das Bodenelement 10 und das Deckelelement 20 im wesentlichen gleich groß ausgebildet sind, das heißt, daß das Deckelelement 20 nun im auf das Bodenelement 10 geklappten Zustand dieses im wesentlichen vollständig überdeckt. Dem Fachmann ist aber klar ersichtlich, daß ein derartiger Unterschied zwischen den Boden- und Deckelementen 10, 20 der beiden Ausführungsbeispiele eine beliebige andere Ausgestaltung des Konstruktionsprinzips des ersten Ausführungsbeispiels darstellt.

Desweiteren sind bei der Gehäuseeinrichtung 1' das Bodenelement 10 und das Deckelelement 20 nicht mehr über zwei Verbindungselemente 31a, 31 b, sondern über drei Verbindungselemente 31a', 31b, 31c verbunden. Auch dies stellt lediglich eine der vielen Varianten dar, das Bodenelement 10 mit dem Deckelelement 20 zu verbinden. Selbstverständlich ist es auch bei der Gehäuseeinrichtung 1' möglich, daß die Verbindungselemente 31a, 31c entfallen, so daß dann die Gehäuseeinrichtung 1' aus separaten Teilen 10, 20 besteht.

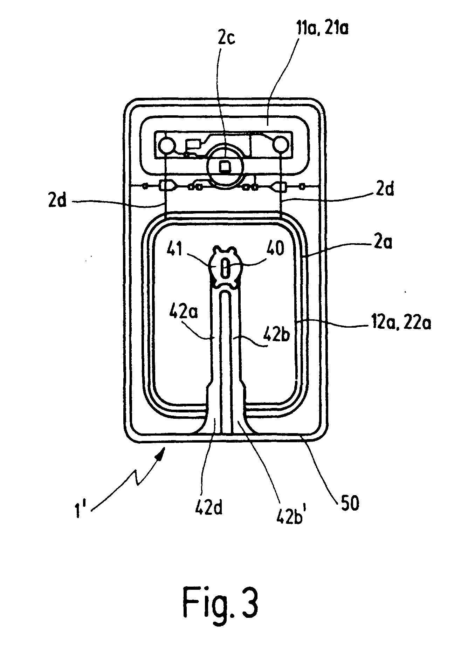

Das Bodenelement 10 der Gehäuseeinrichtung 1' weist zwei den Vertiefungen 11 und 12 der Gehäuseeinrichtung 1 entsprechende Vertiefungen 11a und 12a auf, wobei die Vertiefung 11a nun zur Aufnahme des Mikrochips 2c (siehe Figur 3) dient. Die Vertiefung 12a dient zur Aufnahme des Antennenelements 2a. Wie aus den Figuren 2 und 3 wiederum leicht ersichtlich ist, ist die Randkontur 11a', 12a' der Vertiefungen 11a, 12a auf die Außenkontur 2a', 2c' der jeweiligen Bauteile, 2a, 2c der elektronischen Schaltung 2 abgestimmt, so daß bei der Gehäuseeinrichtung 1' auch diese Bauteile 2a, 2c der elektronischen Schaltung 2 im wesentlichen lagefixiert im Bodenelement 10 der Gehäuseeinrichtung 1' aufgenommen sind.

Wie auch bei der Gehäuseeinrichtung 1 ist bei der Gehäuseeinrichtung 1' vorgesehen, daß das Deckelelement 20 eine mit der Vertiefung 11a des Bodenelements 10 zusammenwirkende weitere Vertiefung 21a sowie eine mit der Vertiefung 12a des Bodenelements 10 zusammenwirkende weitere Vertiefung 22a aufweist, welche im montierten Zustand der Gehäuseeinrichtung 1' über der Vertiefung 11a beziehungsweise 12a liegen. Demzufolge ist bei der Gehäuseeinrichtung 1' der in die Vertiefung 11a aufgenommene Mikrochip 2c vom Deckelelement 20 gegen thermische und/oder mechanische Einflüsse abgeschirmt. Der obere Bereich des Deckelelements 20 der Gehäuseeinrichtung 1' erstreckt sich also hier - im Gegensatz zu demjenigen der Gehäuseeinrichtung 1 der Figur 1 - über die volle Breite b des Deckelelements 20. In entsprechender Art und Weise ist das in der Vertiefung 12a aufgenommene Antenneelement 2a vollständig vom Deckelelement 20 abgedeckt, um dieses gegen die Einwirkung von mechanischen und/oder thermischen Einflüssen zu schützen.

Wie aus der Figur 2 ersichtlich ist, ist bei dem Deckelelement 20 der Gehäuseeinrichtung 1' vorgesehen, daß zur besseren Anpassung der Vertiefung 21a an das darin aufzunehmende Bauteil 2c diese mit weiteren Vertiefungen 25a-25d ausgestattet ist, die dazu dienen, die Vertiefung 21a des Deckelelements 20 besser der Struktur des darin aufzunehmenden Mikrochips 2c anzupassen.

Aus der Figur 2 ist noch ersichtlich, daß das Bodenelement 10 zwei Klemmelemente 29a, 29b für in Figur 2 nicht gezeigte Verbindungsdrähte 2d, welche den in der Vertiefung 11a aufgenommenen Mikrochip und das in der Vertiefung 12a aufgenommene Antennenelement 2a verbinden, aufweist. Durch diese Klemmelemente 29a, 29b werden die Verbindungsdrähte 2d gegen das Deckelelement 20 der Gehäuseeinrichtung 1' gedrückt und derart festgehalten. Es ist aber auch möglich, daß eines oder beide der Klemmelemente 29a, 29b am Deckelelement 20 angeordnet sind.

Ein weiterer Unterschied zwischen den beiden Ausführungsbeispielen besteht darin, daß die Gehäuseeinrichtung 1' eine eine im wesentlichen in der Mitte ihres Deckeleelements 20 angeordnete Öffnung 40 aufweist, die im zusammengeklappten Zustand der Gehäuseeinrichtung 1 über einer Vertiefung 41 im Bodenelement 10 liegt. Von der Vertiefung 41 aus erstrecken sich zwei Kanäle 42a, 42b im Bodenelement 10 zu dessen Rand 10c hin, welche im zusammengeklappten Zustand der Gehäuseeinrichtung 1 von entsprechenden Abdeckungen 43a, 43b im Deckelelement 20 überdeckt sind. Selbstverständlich ist es alternativ auch möglich, die Öffnung 40 im Bodenelement 10 und die Bauteile 41, 42a, 42b im Deckelelement 20 der Gehäuseeinrichtung 1' anzuordnen.

Die Öffnung 40 im Deckelelement 20 sowie die Kanäle 42a, 42b im Bodenelement 10 dienen dazu, daß von der Mitte der Gehäuseeinrichtung 1' her die in Figur 3 ersichtliche Ummantelung 50 der Gehäuseeinrichtung 1' zur Ausbildung der endgültigen Karte hergestellt werden kann, indem durch die Gehäuseeinrichtung 1 in ihrem zusammengeklappten Zustand, in dem die die Gehäuseeinrichtung 1' zu schützenden Bauteile, 2a, 2c im Inneren der Gehäuseeinrichtung 1' aufgenommenen und vom Bodenelement 10 und vom Deckelelement 20 überdeckt sind, in ein Kunststoff-Spritzgußwerkzeug derart eingelegt wird, daß längs des Umfangsrands der Gehäuseeinrichtung 1' ein schmaler Freiraum bleibt. Die Spritzgußmasse wird dann durch die Öffnung 40 in die Kanäle 42a, 42b eingeleitet und durch diese zu der Austrittsöffnung 42a', 42b' der Kanäle 42a, 42b geleitet und ummantelt dann die Gehäuseeinrichtung 1 zur fertigen elektronischen Karte, indem die Spritzgußmasse längs des Außenrands der Gehäuseeinrichtung 1 fließt und derart die umlaufende Ummantelung 50 ausbildet. Eine derartige Vorgangsweise besitzt den Vorteil, daß die Oberfläche der Gehäuseeinrichtung 1' hermetisch dicht ausgebildet sein kann. Außerdem tritt hierbei in vorteilhafter Art und Weise kein Brechen der Gehäuseeinrichtung 1' bei einer Biegebelastung auf.

## Patentansprüche

1. Elektronische Karte für elektromagnetisch bewirkten Datenaustausch, die eine elektronische Schaltung (2) aufweist, die in einer Gehäuseeinrichtung (1; 1') aufgenommen ist, **dadurch gekennzeichnet, daß** die Gehäuseeinrichtung (1; 1') mindestens ein Bodenelement (10) und mindenstens ein Deckelelement (20) aufweist, daß die elektronische Schaltung (2) zwischen den Innenflächen (10', 20') dieser beiden Elemente (10, 20) aufgenommen ist, daß im Bodenelement (10) und/oder im Deckelelement (20) zumindest eine Vertiefung (11, 12, 21, 22; 11a, 12a, 21a, 22a) ausgebildet ist, in der die elektronische Schaltung (2) eingesetzt ist, daß die Kontur (11', 12', 21', 22'; 11a', 12a', 21a', 22a') der Vertiefung (11, 12, 21, 22; 11a, 12a, 21a, 22a) auf die Außenkontur (2a', 2b', 2c',; 2a', 2c') der elektronischen Schaltung (2) abgestimmt ist, daß das Deckelelement (20) die elektronische Schaltung (2) zumindest teilweise überdeckt, und daß die Gehäuseeinrichtung (1; 1') durch eine Ummantelung (50) aus Kunststoff umgeben ist.

2. Elektronische Karte nach Anspruch 1, **dadurch gekennzeichnet, daß** die Gehäuseeinrichtung (1; 1') durch ein Spritzgußverfahren hergestellt ist.

3. Elektronische Karte nach Anspruch 1, **dadurch gekennzeichnet, daß** das Bodenelement (10) und/oder das Deckelelement (20) der Gehäuseeinrichtung (1) zumindest eine Öffnung (13, 23) aufweist, in die ein elektronisches Bauteil (2c) eingesetzt ist.

4. Elektronische Karte nach Anspruch 1 oder 3, **dadurch gekennzeichnet, daß** das Bodenelement (10) und/oder das Deckelelement (20) Aussparungen (24a,24b) zur Aufnahme von Bestandteile (2a-2c) der elektronischen Schaltung (2) verbindenden elektrische Verbindungselemente (2d) aufweist.

5. Elektronische Karte nach einem der vorangehenden Ansprüche, **dadurch gekennzeichnet, daß** das Deckelelement (20) mit dem Bodenelement (10) der Gehäuseeinrichtung (1; 1') über Verbindungselemente (31a,31b; 31a-31c) verbunden ist, um die das Deckelelement (20) auf das Bodenelement (10) schwenkbar ist.

6. Elektronische Karte nach einem der vorangehenden Ansprüche, **dadurch gekennzeichnet, daß** das Bodenelement (10) und das Deckelelement (20) der Gehäuseeinrichtung (1), vorzugsweise durch Verkleben, Verschweißen, Verrasten oder Verklemmen, verbunden ist.

7. Elektronische Karte nach einem der vorangehenden Ansprüche, **dadurch gekennzeichnet, daß** das Bodenelement (10) eine durch zwei Längsränder (10a,10b) und zwei Querränder (10c,10d) begrenzte, im wesentlichen rechteckige Grundfläche aufweist, oder daß das Bodenelement (10) eine runde, ovale oder polygonale Grundfläche aufweist, und daß die Grundfläche des Bodenelements (10) etwas kleiner als diejenige der elektronischen Karte ist.

8. Elektronische Karte nach einem der vorangehenden Ansprüche, **dadurch gekennzeichnet, daß** die Vertiefungen (21,22;21a,22a) des Deckelelements (20) im montierten Zustand der Gehäuseeinrichtung (1;1') über den Vertiefungen (11,12;11a,12a) des Bodenelements (10) der Gehäuseeinrichtung (1;1') liegen.

9. Elektronische Karte nach einem der vorangehenden Ansprüche, **dadurch gekennzeichnet, daß** die Gehäuseeinrichtung (1;1') aus elastischem oder starren Kunststoffmaterial gefertigt ist.

10. Elektronische Karte nach einem der vorangehenden Ansprüche, **dadurch gekennzeichnet, daß** sich das Deckelelement (20) der Gehäuseeinrichtung (1) im zusammengeklappten Zustand der Gehäuseeinrichtung (1) in mindestens einem Bereich nicht über die volle Breite des Bodenelements (10) erstreckt.

11. Elektronische Karte nach einem der Ansprüche 1 bis 9, **dadurch gekennzeichnet, daß** das Deckelelement (20) und das Bodenelement (10) der Gehäuseeinrichtung (1') sich im zusammengeklappten Zustand der Gehäuseeinrichtung (1') im wesentlichen überdecken.

12. Elektronische Karte nach einem der vorangehenden Ansprüche, **dadurch gekennzeichnet, daß** in einem der beiden Elemente (10, 20) der Gehäuseeinrichtung (1') eine Öffnung (40) vorgesehen ist, durch die Spritzgußmaterial einleitbar ist, daß die Öffnung (40) mit mindestens einem zum Rand der Gehäuseeinrichtung (1') verlaufenden Kanal (42a, 42b) verbunden ist, so daß das durch die Öffnung (40) einbringbare Spritzgußmaterial durch den mindestens einen Kanal (42a, 42b) im Inneren der Gehäuseeinrichtung (1') zu deren Rand leitbar ist.

13. Elektronische Karte nach einem der vorangehenden Ansprüche, **dadurch gekennzeichnet, daß** die erste Vertiefung (11a, 21 a) und die zweite Vertiefung (12a, 22a) des Bodenelements (10) und/oder des Deckelelements (20) der Gehäuseeinrichtung (1') durch Klemmelemente (29a, 29b) verbunden sind, durch die die beiden Bauteile (2a, 2c) der elektronischen Schaltung (2) verbindende Verbindungsdrähte (2d) gegen das Deckelelement (20) und/oder das Bodenelement (10) der Gehäuseeinrichtung (1') angedrückt sind.

14. Elektronische Karte nach einem der vorangehenden Ansprüche, **dadurch gekennzeichnet, daß** mindestens eines der in einer der Vertiefungen (11,12; 21,22;11a,12a,21a,22a) des Bodenelements (10) und/oder desDeckelelements (20) der Gehäuseeinrichtung (1; 1) aufnehmbaren elektronischen Bauteile ein Antennenelement (2a,2b) oder ein Mikrochip (2c) ist.

15. Verfahren zur Herstellung einer eine elektronische Schaltung (2) aufweisenden elektronische Karte für elektromagnetisch bewirkten Datenaustausch, bei dem in einem ersten Arbeitsschritt eine ein Bodenelement (10) und ein Dekkelelement (20) aufweisende Gehäuseeinrichtung (1; 1') durch ein Spritzgußverfahren gefertigt wird, die im Bodenelement (10) und/oder im Deckelelement (20) zumindest eine Vertiefung (11,12, 21, 22; 11a, 12a, 21a, 21b) aufweist, bei dem in einem darauffolgenden Arbeitsschritt Bauelemente (2a-2d) der in der Gehäuseeinrichtung (1; 1') aufzunehmenden elektronischen Schaltung (2) in die zumindest eine Vertiefung (11,12; 11a, 12a) des Bodenelements (10) eingelegt werden, bei dem in einem darauffolgenden Arbeitsschritt das Deckelelement (20) derart auf dem Bodenelement (10) fixiert wird, daß durch das Deckelelement (10) die in den Vertiefungen (11,12) des Bodenelements (10) aufgenommene elektronische Schaltung (2) zumindest teilweise überdeckt wird, und daß die Gehäuseeinrichtung (1) in ein Spritzguß-Werkzeug eingelegt und zur Ausbildung der elektronischen Karte mit Kunststoff ummantelt wird.

16. Verfahren nach Anspruch 15, **dadurch gekennzeichnet, daß** das Bodenelement (10) und das Deckelelement (20) der Gehäuseeinrichtung (1; 1') durch Verbindungselemente (31 a, 31 b; 31a-31c) verbunden werden.

17. Verfahren nach einem der Ansprüche 15 oder 16, **dadurch gekennzeichnet, daß** im Bodenelement (10) und/oder im Deckelelement (20) der Gehäuseeinrichtung (1) mindestens zwei Vertiefungen (11,12, 21,22; 11a, 12a, 21a, 22a) vorgesehen werden, und daß im Bodenelement (10) und/oder im Deckelelement (20) Aussparungen (24a,24b) für Verbindungsdrähte (2d) der elektronischen Schaltung (2) vorgesehen werden.

18. Verfahren nach einem der Ansprüche 15 bis 17, **dadurch gekennzeichnet, daß** im Bodenelement (10) und/oder Deckelement (20) der Gehäuseeinrichtung (1') mindestens zwei Klemmelemente (29a, 29b) für Verbindungsdrähte (2d) der elektronischen Schaltung (2) vorgesehen werden.

19. Verfahren nach einem der vorangehenden Ansprüche, **dadurch gekennzeichnet, daß** das Bodenelement (10) und das Deckelelement (20) der Gehäuseeinrichtung (1;1') zumindest teilweise zur Fixierung des Deckelelements (20) auf dem Bodenelement (10) verbunden werden.

20. Verfahren nach einem der vorangehenden Ansprüche, **dadurch gekennzeichnet, daß** die Gehäuseeinrichtung (1;1') aus elastischem Kunststoffmaterial gefertigt wird.

21. Verfahren nach einem der Ansprüche 15 bis 19, **dadurch gekennzeichnet, daß** die Gehäuseeinrichtung (1) aus starrem Kunststoffmaterial gefertigt ist.

## Claims

1. Electronic card for electromagnetic data exchange, the electronic card having an electronic circuit (2), which is contained in a housing (1; 1'), **characterised in that** the housing (1, 1') has at least one bottom element (10) and at least one top element (20), in that the electronic circuit (2) is contained between the inner surfaces (10', 20') of these two elements (10, 20), that the bottom element (10) and/or the top element (20) is provided with at least one recess (11, 12, 21, 22; 11a, 12a, 21 a, 22a), into which the electronic circuit (2) is inserted, that the shape (11', 12', 21', 22'; 11a', 12a', 21a', 22a') of the recess (11, 12, 21, 22; 11a, 12a, 21 a, 22a) corresponds to the outer shape (2a', 2b', 2c'; 2a', 2c') of the electronic circuit (2), that the top element (20) covers the electronic circuit (2) at least partially, and that the housing (1; 1') is encased by a sheathing (50) made of plastics.

2. Electronic card according to claim 1, **characterised in that** the housing device (1; 1') is produced via an injection moulding process.

3. Electronic card according to claim 1, **characterised in that** the bottom element (10) and/or the top element (20) of the housing (1) is provided with at least one opening (13, 23) into which an electronic component (2c) is inserted.

4. Electronic card according to claim 1 or 3, **characterised in that** the bottom element (10) and/or the top element (20) are provided with recesses (24a, 24b) for receiving electrical connecting elements (2d) serving to connect components (2a-2c) of the electronic circuit (2).

5. Electronic card according to one of the previous claims, **characterised in that** the top element (20) is connected to the bottom element (10) of the housing (1; 1') via connecting elements (31a, 31b; 31a-31c), around which the top element (20) can be folded onto the bottom element (10).

6. Electronic card according to one of the previous claims, **characterised in that** the bottom element (10) and the top element (20) of the housing device (1) are connected, preferably by glueing, welding, engaging via notches or via clamping, with each other.

7. Electronic card according to one of the previous claims, **characterised in that** the bottom element (10) has a generally rectangular surface limited by two longitudinal edges (10a, 10b) and by two cross edges (10c, 10d), or that the bottom element (10) is of a circular, oval or polygonal shape, and that the surface of the bottom element (10) is somewhat smaller than the one of the electronic card.

8. Electronic card according to one of the previous claims, **characterised in that** the recesses (21, 22; 21 a, 22a) of the top element (20) are positioned above the recesses (11, 12; 11a, 12a) of the bottom element (10) of the housing (1; 1') when the housing (1; 1') is in its assembled state.

9. Electronic card according to one of the previous claims, **characterised in that** the housing (1; 1') is made of elastic or rigid plastic material.

10. Electronic card according to one of the previous claims, **characterised in that** the top element (20) of the housing (1) does not extend over the entire width of the bottom element (10) in at least one area when the housing device is in its folded-up state.

11. Electronic card according to one of the claims 1 to 9, **characterised in that** the top element (20) and the bottom element (10) of the housing device (1') generally overlap one another when the housing device (1') is in its folded-up state.

12. Electronic card according to one of the previous claims, **characterised in that** in one of the two elements (10, 20) of the housing (1') there is provided an opening (40) through which an injection-moulding material can be conveyed, that the opening (40) is connected to at least one channel (42a, 42b) running towards the edge of the housing (1'), so that the injection-moulding material which can be conveyed via the opening (40) can pass through the at least one channel (42a, 42b) inside the housing (1') towards the edge of the housing (1').

13. Electronic card according to one of the previous claims, **characterised in that** the first recess (11a, 21a) and the second recess (12a, 22a) of the bottom element (10) and/or of the top element (20) of the housing (1') are connected by clamp elements (29a, 29b), by means of which the connecting wires (2d) serving to connect the two components (2a, 2c) of the electronic circuit (2) are pushed against the top element (20) and/or the bottom element (10) of the housing (1').

14. Electronic card according to one of the previous claims, **characterised in that** at least one of the electronic components which can be received within one of the recesses (11, 12; 21, 22; 11a, 12a, 21a, 22a) of the bottom element (10) and/or of the top element (20) of the housing device (1; 1) is an antenna element (2a, 2b) or a microchip (2c).

15. Process for the manufacturing of an electronic card for electromagnetic data exchange, the electronic card having an electronic circuit (2), whereby in a first step of operation a housing (1; 1') having a bottom element (10) and a top element (20) is made by an injection-moulding process, which has in the bottom element (10) and/or in the top element (20) at least one recess (11, 12, 21, 22; 11a, 12a, 21 a, 21 b), whereby in a subsequent step of operation components (2a-2d) of the electronic circuit (2) to be received within the housing (1; 1') are inserted into the at least one recess (11,12; 11a, 12a) of the bottom element (10), whereby in a further step of operation the top element (20) is fixed onto the bottom element (10) in such a way that the electronic circuit (2) received within the recesses (11, 12) of the bottom element (10) is at least partially covered by the top element (10), and whereby the housing (1) is placed into an injection-moulding tool to be encased in plastic material in order to create the electronic card.

16. Process according to claim 15, **characterised in that** the bottom element (10) and the top element (20) of the housing (1; 1') are connected to each other via connecting elements (31 a, 31b; 31a-31c).

17. Process according to one of the claims 15 or 16, **characterised in that** at least two recesses (11, 12, 21, 22; 11a, 12a, 21a, 22a) are provided in the bottom element (10) and/or in the top element (20) of the housing (1), and that recesses (24a, 24b) for connecting wires (2d) of the electronic circuit (2) are provided in the bottom element (10) and/or in the top element (20).

18. Process according to one of the claims 15 to 17, **characterised in that** at least two clamp elements (29a, 29b) for connecting wires (2d) of the electronic circuit (2) are provided in the bottom element (10) and/or in the top element (20) of the housing (1').

19. Process according to one of the previous claims, **characterised in that** the bottom element (10) and the top element (20) of the housing (1; 1') are connected at least partially in order to fix the top element (20) onto the bottom element (10).

20. Process according to one of the previous claims, **characterised in that** the housing (1; 1') is made of an elastic plastic material.

21. Process according to one of the claims 15 to 19, **characterised in that** the housing (1) is made of a rigid plastic material.

## Revendications

1. Carte électronique pour des échanges de données mis en oeuvre par voie électromagnétique, qui présente un circuit électronique (2) qui vient se loger dans un mécanisme de boîtier (1; 1'), **caractérisée en ce que** le mécanisme de boîtier (1; 1') présente au moins un élément de base (10) et au moins un élément de recouvrement (20), en ce que le circuit électronique (2) vient se loger entre les surfaces internes (10', 20') de ces deux éléments (10, 20), en ce que, dans l'élément de base (10), est réalisé au moins un renfoncement (11, 12, 21, 22; 11a, 12a, 21a, 22a) dans lequel est inséré le circuit électronique (2), en ce que le contour (11', 12', 21', 22'; 11a', 12a', 21a', 22a') du renfoncement (11, 12, 21, 22; 11a, 12a, 21a, 22a) épouse la forme du contour externe (2a', 2b', 2c'; 2a', 2c') du circuit électronique (2), en ce que l'élément de recouvrement (20) recouvre le circuit électronique (2) au moins en partie, et en ce que le mécanisme de boîtier (1 1') est entouré par une enveloppe (50) en matière synthétique.

2. Carte électronique selon la revendication 1, **caractérisée en ce que** le mécanisme de boîtier (1; 1') est fabriqué via un procédé de moulage par injection.

3. Carte électronique selon la revendication 1, **caractérisée en ce que** l'élément de base (10) et/ou l'élément de recouvrement (20) du mécanisme de boîtier (1) présentent au moins une ouverture (13, 23) dans laquelle est inséré un composant électronique (2c).

4. Carte électronique selon la revendication 1 ou 3, **caractérisée en ce que** l'élément de base (10) et/ou l'élément de recouvrement (20) présentent des évidements (24a, 24b) pour que viennent s'y loger des éléments de liaison électrique (2d) reliant des composants (2a - 2c) du circuit électronique (2).

5. Carte électronique selon l'une quelconque des revendications précédentes, **caractérisée en ce que** l'élément de recouvrement (20) est relié à l'élément de base (10) du mécanisme de boîtier (1, 1') via des éléments de liaison (31a, 31b; 31a - 31c), autour desquels l'élément de recouvrement (20) est à même de pivoter sur l'élément de base (10).

6. Carte électronique selon l'une quelconque des revendications précédentes, **caractérisée en ce que** l'élément de base (10) et l'élément de recouvrement (20) du mécanisme de boîtier (1) sont reliés de préférence par collage, par soudage, par encliquetage ou par serrage.

7. Carte électronique selon l'une quelconque des revendications précédentes, **caractérisée en ce que** l'élément de base (10) présente une surface de base essentiellement rectangulaire, délimité par deux bords longitudinaux (10a, 10b) et par deux bords transversaux (10c, 10d), ou bien en ce que l'élément de base (10) présente une surface de base ronde, ovale ou polygonale, et en ce que la surface de base de l'élément de base (10) est légèrement inférieure à celle de la carte électronique.

8. Carte électronique selon l'une quelconque des revendications précédentes, **caractérisée en ce que** les renfoncements (21, 22; 21a, 22a) de l'élément de recouvrement (20) à l'état monté du mécanisme de boîtier (1; 1') sont disposés par-dessus les renfoncements (11, 12; 11a, 12a) de l'élément de base (10) du mécanisme de boîtier (1; 1').

9. Carte électronique selon l'une quelconque des revendications précédentes, **caractérisée en ce que** le mécanisme de boîtier (1; 1') est réalisé en une matière synthétique élastique ou rigide.

10. Carte électronique selon l'une quelconque des revendications précédentes, **caractérisée en ce que** l'élément de recouvrement (20) du mécanisme de boîtier (1) à l'état replié du mécanisme de boîtier (1) ne s'étend pas, dans au moins une zone, sur toute la largeur de l'élément de base (10).

11. Carte électronique selon l'une quelconque des revendications 1 à 9, **caractérisée en ce que** l'élément de recouvrement (20) et l'élément de base (10) du mécanisme de boîtier (1') se recouvrent essentiellement à l'état replié du mécanisme de boîtier (1').

12. Carte électronique selon l'une quelconque des revendications précédentes, **caractérisée en ce qu'**on prévoit, dans un des deux éléments (10, 20) du mécanisme de boîtier (1'), une ouverture (40) à travers laquelle on peut introduire la matière de moulage par injection, en ce que l'ouverture (40) est reliée à au moins un canal (42a, 42b) s'étendant jusqu'au bord du mécanisme de boîtier (1') de telle sorte que la matière de moulage par injection que l'on peut introduire à travers l'ouverture (40) peut être guidée, à travers ledit canal ou lesdits canaux (42a, 42b) à l'intérieur du mécanisme de boîtier (1') jusqu'au bord de ce dernier.

13. Carte électronique selon l'une quelconque des revendications précédentes, **caractérisée en ce que** le premier renfoncement (11a, 21a) et le deuxième renfoncement (12a, 22a) de l'élément de base (10) et/ou de l'élément de recouvrement (20) du mécanisme de boîtier (1') sont reliés par des éléments de serrage (29a, 29b) par lesquels les fils de liaison (2d) reliant les deux composants (2a, 2b) du circuit électronique (2) sont pressés contre l'élément de recouvrement (20) et/ou l'élément de base (10) du mécanisme de boîtier (1').

14. Carte électronique selon l'une quelconque des revendications précédentes, **caractérisée en ce qu'**au moins un des composants électroniques (2a, 2b) aptes à venir se loger dans un des renfoncements (11, 12; 21, 22; 11a, 12a, 21a, 22a) de l'élément de base (10) et/ou de l'élément de recouvrement (20) du mécanisme de boîtier (1; 1') est un élément d'antenne (2a, 2b) ou une micropuce (2c).

15. Procédé pour la fabrication d'une carte électronique présentant un circuit électronique (2) pour des échanges de données mis en oeuvre par voie électromagnétique, dans lequel, dans une première étape de travail, on réalise un mécanisme de boîtier (1; 1') présentant un élément de base (10) et un élément de recouvrement (20) via un procédé de moulage par injection, qui présente dans l'élément de base (10) et/ou dans l'élément de recouvrement (20) au moins un renfoncement (11, 12, 21, 22; 11a, 12a, 21a, 22a); dans lequel, dans une étape de travail suivante, on insère des composants (2a - 2d) du circuit électronique (2) qui doit venir se loger dans le mécanisme de boîtier (1; 1'), dans le ou les renfoncements (11, 12; 11a, 12a) de l'élément de base (10); dans lequel, dans une étape de travail suivante, on fixe l'élément de recouvrement (20) par-dessus l'élément de base (10) de telle sorte que le circuit électronique (2) qui vient se loger dans les renfoncements (11, 12) de l'élément de base (10) est recouvert au moins en partie par l'élément de recouvrement (20), et dans lequel on introduit le mécanisme de boîtier (1) dans un moule de moulage par injection et on l'enveloppe avec une matière synthétique pour réaliser la carte électronique.

16. Procédé selon la revendication 15, **caractérisé en ce que** l'élément de base (10) et l'élément de recouvrement (20) du mécanisme de boîtier (1; 1') sont reliés par des éléments de liaison (31a, 31b; 31a - 31c).

17. Procédé selon l'une quelconque des revendications 15 ou 16, **caractérisé en ce que**, dans l'élément de base (10) et/ou dans l'élément de recouvrement (20) du mécanisme de boîtier (1), on prévoit au moins deux renfoncements (11, 12, 21, 22; 11a, 12a, 21a, 22a), et en ce que, dans l'élément de base (10) et/ou dans l'élément de recouvrement (20), on prévoit des évidements (24a, 24b) pour des fils de liaison (2d) du circuit électronique (2).

18. Procédé selon l'une quelconque des revendications 15 à 17, **caractérisé en ce que**, dans l'élément de base (10) et/ou dans l'élément de recouvrement (20) du mécanisme de boîtier (1'), on prévoit au moins deux éléments de serrage (29a, 29b) pour des fils de liaison (2d) du circuit électronique (2).

19. Procédé selon l'une quelconque des revendications précédentes, **caractérisé en ce que** l'élément de base (10) et l'élément de recouvrement (20) du mécanisme de boîtier (1; 1') sont reliés au moins en partie pour la fixation de l'élément de recouvrement (20) sur l'élément de base (10).

20. Procédé selon l'une quelconque des revendications précédentes, **caractérisé en ce que** le mécanisme de boîtier (1; 1') est réalisé en une matière synthétique élastique.

21. Procédé selon l'une quelconque des revendications 15 à 19, **caractérisé en ce que** le mécanisme de boîtier (1) est réalisé en une matière synthétique rigide.
